# EUROPÄISCHE PATENTSCHRIFT

(11) **EP 3 441 795 B1**
(45) Veröffentlichungstag und Bekanntmachung des Hinweises auf die Patenterteilung: **08.01.2020**
(21) Anmeldenummer: 18183237.9
(22) Anmeldetag: 12.07.2018
(51) Int. Cl.: G01V 8/10, G01S 17/02, G01S 7/481

(54) **SENSOR ZUR ERFASSUNG EINES OBJEKTS UND VERFAHREN ZUM EINSTELLEN EINES SCHALTPUNKTES**
SENSOR FOR DETECTING AN OBJECT AND METHOD FOR ADJUSTING A SWITCHING POINT
CAPTEUR DESTINÉ À LA DÉTECTION D'UN OBJET ET PROCÉDÉ DE RÉGLAGE D'UN POINT DE COMMUTATION

(30) Priorität: 09.08.2017 DE 102017118083
(43) Veröffentlichungstag der Anmeldung: 13.02.2019
(73) Patentinhaber: Sick AG, 79183 Waldkirch (DE)
(72) Erfinder: Waslowski, Kai, 79183 Waldkirch (DE)

(56) Entgegenhaltungen:
- WO-A1-2016/095882
- WO-A1-2016/110844
- DE-A1- 10 251 350
- DE-A1- 10 329 881
- DE-A1- 10 353 981
- DE-A1- 19 730 341
- DE-A1-102008 050 943
- DE-A1-102010 032 042
- DE-A1-102011 050 119
- DE-B3-102008 020 416
- DE-U1-202007 004 364

## Beschreibung

Die Erfindung betrifft ein System zur Erfassung eines Objekts und ein Verfahren zum Einstellen eines Schaltpunkts nach dem Oberbegriff von Anspruch 1 beziehungsweise 11.

Die Erfassung eines Objekts ist eine grundlegende Funktion verschiedenster Sensoren, von induktiven, magnetischen oder kapazitiven Sensoren über Ultraschallsensoren bis hin zu optoelektronischen Sensoren. Zu jedem physikalischen Prinzip gibt es wieder Unterfamilien. Zu den optoelektronischen Sensoren zählen Einweg- und Reflexionslichtschranken, die Unterbrechungen oder Abschwächungen eines direkt oder über einen Reflektor auf einen Lichtempfänger gerichteten Lichtstrahls erkennen. Auch Kameras in diversen Spielarten einschließlich Zeilen- und 3D-Kameras sind optoelektronische Sensoren.

Eine weitere Gruppe bilden die Lichttaster, deren Lichtstrahl tastend in den Überwachungsbereich geführt und nur dann in einem Lichtempfänger registriert wird, wenn sich ein Objekt im Überwachungsbereich befindet, an dem der Lichtstrahl zurückgeworfen wird. Ein energetischer Taster bewertet die Intensität des Empfängersignals anhand einer Schaltschwelle. Ein Kontrasttaster erkennt Helligkeits- oder Farbunterschiede. Bei einem Triangulationstaster stehen die optischen Achsen von Lichtsender und Lichtempfänger schräg zueinander, und mit Hilfe eines ortsauflösenden Lichtempfängers kann der Winkel gemessen werden, unter dem ein Objekt erfasst wird, und so eine Entfernung bestimmt werden. Bei sogenannten hintergrundausblendenden Lichttastern, wie beispielsweise in der DE 197 21 105 C2 offenbart, wird der Aufbau eines Triangulationstasters ausgenutzt, um mit einem zumindest in einen Nah- und einen Fernbereich ortsauflösenden Lichtempfänger zwei Empfangssignale zu erzeugen. Deren Differenz wird mit einer Schaltschwelle bewertet, um so die Objekterfassung auf einen bestimmten Entfernungsbereich zu beschränken und Empfangssignale von Objekten außerhalb dieses Entfernungsbereichs als Hintergrundsignal auszublenden.

Die hier betrachteten schaltenden Sensoren können zwar auf verschiedensten Wegen Informationen aufnehmen, das Ziel ist aber ein binäres Gegenstandsfeststellungssignal, dessen Zustand anzeigt, ob ein Objekt, das gegebenenfalls noch gewisse Eigenschaften aufweisen muss, erfasst ist oder nicht. Damit die gewünschten Objekte detektiert werden, muss der sogenannte Schaltpunkt eingestellt sein. Dieser Schaltpunkt legt eine oder mehrere Schwellen, Hysteresen oder Verarbeitungsregeln fest, mit denen die erfassten Sensor- oder Messsignale in das binäre Gegenstandsfeststellungssignal umgerechnet werden. Einfache Beispiele sind eine Pegelschwelle, ab welcher der Lichtstrahl einer Lichtschranke als unterbrochen gilt, oder ein Abstand, ab dem ein Objekt von einem hintergrundausblendenden Taster ignoriert wird.

Im Stand der Technik wird der Schaltpunkt über ein Potentiometer, einen Encoder oder einen digitalen Zahlenwert festgelegt, wobei letzterer zuvor ermittelt und über eine Parametrierschnittstelle beispielsweise auf Basis von IO-Link übergeben werden muss. Herkömmliche Sensoren bieten dafür einen Einlernvorgang ("Teach") an, der durch einen Tastendruck ausgelöst wird. Der Schaltpunkt wird üblicherweise so eingestellt, dass das Objekt gerade erkannt wird, entspricht demnach beispielsweise bei einem Triangulationstaster gerade der aktuellen Objektentfernung.

Diese Schaltpunktjustage mit genau einem Referenzobjekt berücksichtigt nicht die mögliche Variation der zu detektierenden Vordergrund- und Hintergrundobjekte. Um im Beispiel des Triangulationslichttasters zu bleiben, ergeben sich immer gewisse Abweichungen zwischen der realen und der gemessenen Objektdistanz abhängig von den Oberflächeneigenschaften der zu detektierenden Objekte wie Glanz, Bedruckung, Inhomogenitäten und dergleichen. Außerdem unterliegen auch die Positionen und Abmessungen der Objekte selbst Toleranzen. Würde man bei der Einstellung des Schaltpunktes alle theoretisch denkbaren Extreme, wie schwarzen Samt und weiße, ideal remittierende Körper oder optische Spiegel unter beliebigen Winkel, und damit alle theoretisch möglichen Detektionsfehler und -abweichungen berücksichtigen, so müsste der minimale Abstand zwischen dem realen Objekt und dem realen Hintergrund so groß werden, wie dies in üblichen Anwendungen des Sensors gar nicht umsetzbar ist.

Die pragmatische praktische Lösung ist, in kritischen Anwendungen so lange herumzuprobieren, bis der eingestellte Schaltpunkt eine zufriedenstellende Trennung zwischen Objekt und Hintergrund erlaubt. Dieses manuelle Vorgehen funktioniert sogar meist zufriedenstellend, weil die Anwender ein Gefühl dafür entwickelt haben, wieviel Reserve für eine ausreichende Robustheit auf einen Schaltpunkt aufgeschlagen werden muss. Das fordert aber natürlich entsprechend erfahrene Anwender. Außerdem stößt das Verfahren spätestens dann an seine Grenzen, wenn in komplexen Situationen mit unterschiedlichsten Objekten oder einer Vielzahl von intern zur Verfügung stehenden Sensorsignalen selbst die Intuition eines Experten versagt, sich noch geeignete Kriterien für die Bestimmung des Gegenstandsfeststellungssignals vorzustellen.

Die EP 2 975 769 A1 offenbart einen optoelektronischen Sensor mit einem drückbaren Bedienelement, um einen Referenzwert auf einen durch das aktuelle Empfängersignal vorgegebenen Einlernwert festzulegen. Das ist also ein Beispiel für das beschriebene herkömmliche Einlernverfahren.

In der DE 197 18 391 A1 wird ein Histogramm von auftretenden Signalpegeln eines optoelektronischen Sensors gebildet, um eine geeignete Schwelle aufzufinden und später entsprechend der jeweils gegebenen Betriebsbedingungen nachzuführen. Die DE 10 2011 050 119 A1 wertet zum Anpassen der Schwelle nicht nur die Signalpegel, sondern auch deren Varianz oder noch höhere statistische Momente aus. Die DE 10 2015 107 221 A1 befasst sich mit einer Schwellanpassung bei induktiven Sensoren. Bei diesen Ansätzen setzt der Sensor seinen Schaltpunkt und entscheidet damit jeweils selbst, wie eine Detektionssituation zu bewerten ist. Das ist oft hilfreich, muss aber keineswegs mit den tatsächlichen Zielen der Anwendung übereinstimmen.

Aus der DE 197 30 341 A1 ist eine optoelektronische Sensoranordnung bekannt, die durch Aufteilen der Lichtempfangseinheit in mehrere Empfangszonen mehrere Objektzonen überwacht und bei Erkennen eines Objekts innerhalb einer Objektzone ein Gegenstands-Feststellungssignal an dem der Objektzone entsprechenden Schaltausgang erzeugt. Während eines Teach-Vorgangs werden für die später zu erkennenden Objekte charakteristische Referenzobjekte in den Überwachungsbereich eingeführt. Die Merkmale eines lediglich in eine Objektzone eingeführten Referenzobjekts können für eine andere Objektzone übernommen werden.

Die DE 10 2008 020 416 B3 offenbart ein Verfahren zur Detektion von Objekten mittels eines Sensors. Während eines Arbeitsbetriebs erzeugt der Sensor ein binäres Objektfeststellungssignal. In einem Einlernvorgang werden Häufigkeitsverteilungen der generierten Messwerte ermittelt. Dazu wird in einer ersten Stufe allein der Hintergrund vermessen und in einer zweiten Stufe ein Objekt vor dem Hintergrund platziert. Aus den Häufigkeitsverteilungen wird eine Gewichtungsfunktion ermittelt, die in einem ersten und zweiten Bereich Werte annimmt, welche einem ersten und zweiten Schaltzustand des Objektfeststellungssignals entsprechen.

Die DE 103 29 881 A1 offenbart ein Lichtgitter mit Überwachung von Schutzfeldern, welches bestimmte Objekte ohne Auslösen der Schutzfunktion passieren lässt. Dafür wird eine Referenzkontur eines derartigen zulässigen Objekts in Form der jeweils unterbrochenen und nicht unterbrochenen Lichtstrahlen eingelernt. Mit Hilfe eines Positionssensors wird der jeweils im Schutzfeld befindliche Teil der Kontur bestimmt.

Die DE 10 2008 050 943 A1 offenbart ein weiteres Lichtgitter mit Schutzfeldfunktion. Dessen Betriebszustand, insbesondere Muting- oder Blanking-Funktion, wird abhängig von der Bewegungsrichtung von Objekten eingestellt.

Es ist daher Aufgabe der Erfindung, einen Sensor derart weiterzubilden, dass er zuverlässiger arbeitet und die zu detektierende Situation besser erfassen kann.

Diese Aufgabe wird durch ein System zur Erfassung eines Objekts und ein Verfahren zum Einstellen eines Schaltpunkts nach Anspruch 1 beziehungsweise 11 gelöst. Der Sensor des Systems weist mindestens ein Sensorelement auf, um ein Sensorsignal zu erfassen.

Daraus wird ein binäres Gegenstandsfeststellungssignal gewonnen und an einem Schaltausgang ausgegeben. Die Zuordnung zwischen Sensorsignal und Gegenstandsfeststellungssignal wird durch einen Schaltpunt festgelegt, der in einer Einlernphase bestimmt wird. Der Begriff Schaltpunkt orientiert sich an einfachen eindimensionalen Sensoren.

Erfindungsgemäß ist der Begriff aber weit zu verstehen: Das Sensorsignal kann aus mehreren Quellen stammen und mehr- oder sogar hochdimensional sein. Der Schaltpunkt bezeichnet auch dann die Kriterien, die Funktion oder den Klassifikator, mit dem das Sensorsignal bewertet wird, um eine binäre Entscheidung für den Zustand des Gegenstandsfeststellungssignals zu treffen. Im einfachsten Fall handelt es sich um eine reine Anwesenheitsfeststellung. Dies kann aber auch an Zusatzbedingungen gebunden sein, wie bestimmte Abstandsbereiche, in denen sich das Objekt befindet, oder an Objekteigenschaften wie eine Mindest- oder Höchstgröße, eine Farbe oder irgendeine andere Eigenschaft, die anhand des Sensorsignals unterschieden werden kann. Wie das Sensorsignal selbst, können auch solche Zusatzbedingungen komplex werden und beispielsweise wie im Falle einer Hysterese von der Vergangenheit abhängen.

Die Erfindung geht von dem Grundgedanken aus, die Einlernphase als Trainingsphase für ein überwachtes Training des Schaltpunktes auszugestalten. Dazu wird der Sensor mit einer Vielzahl von Detektionssituationen des späteren Betriebs konfrontiert und erfasst dabei sein Sensorsignal. Das jeweils zugehörige Gegenstandsfeststellungssignal wird vorgegeben (supervised learning, tagging, labeling). Vorzugsweise geschieht dies in direktem zeitlichem Zusammenhang, also während oder kurz nach der jeweiligen Detektionssituation, prinzipiell kann dies aber auch nachträglich zusammengeführt oder sogar erst bestimmt werden. Der Schaltpunkt wird nun anhand der gelabelten Trainingsdaten bestimmt, nämlich den Sensorsignalen mit zugehörigem gewünschtem Gegenstandsfeststellungssignal. Beispielsweise wird der Schaltpunkt so gelegt, dass für alle in der Einlernphase gemessenen Sensorsignale das vorgegebene zugehörige Gegenstandsfeststellungssignal reproduziert wird, und zwar für Robustheit mit möglichst großem Abstand des Schaltpunktes zu allen in der Einlernphase gemessenen Sensorsignale. Es ist aber nicht zwingend, dass der Schaltpunkt im Betrieb wirklich alle Gegenstandsfeststellungssignale so bewertet wie im Training, es handelt sich um eine Optimierung mit Abwägung. Möglicherweise ist es besser, wenn der Schaltpunkt ein paar Ausreißer des Trainings falsch klassifiziert, als wenn die Robustheit ganz aufgegeben werden muss.

Die Verknüpfung von Sensorsignalen mit dem jeweiligen vorgegebenen Gegenstandsfeststellungssignal, d.h. das Labeling oder Tagging der Trainingsdaten, sowie das Ableiten eines geeigneten Schaltpunktes findet erfindungsgemäß im Sensor selbst statt, es kann in einem nicht-erfindungsgemäßen Beispiel extern durchgeführt oder von extern unterstützt werden. Der Auswertungseinheit des Sensors wird auch im letzteren Fall das Gegenstandsfeststellungssignal mindestens indirekt vorgegeben, und ein Schaltpunkt im Sinne einer Übernahme des externen Ergebnisses abgeleitet.

Die Erfindung hat den Vorteil, dass die manuelle Justage über Potentiometer, Encoder oder eine Teachtaste durch ein automatisiertes Einstellen des Schaltpunkts ersetzt wird. Der Schaltpunkt berücksichtigt die Variation der Detektionssituationen und ist dadurch viel flexibler und robuster. Es ist nicht länger erforderlich, dass das Einlernen durch Fachleute mit Erfahrung für den Sensor und die Anwendung vorgenommen wird. Der eingestellte Schaltpunkt kann auf andere Sensoren übertragen werden, beispielsweise ein Austauschgerät. Das erfindungsgemäße Einlernen eines Schaltpunktes funktioniert auch noch in komplexen Situationen mit mehrdimensionalen Sensorsignalen und unübersichtlichen Randbedingungen an ein zu erfassendes Objekt. Der Sensor selbst kann aber sehr einfach bleiben, da im Betrieb lediglich die durch den Schaltpunkt vorgegebenen Vergleiche oder Klassifikationen für sein Sensorsignal durchzuführen sind. Das gilt vor allem dann, wenn Rechenaufwand der Einlernphase nach extern ausgelagert ist und der Sensor dies nicht selbst bereitstellen muss.

Der Sensor weist vorzugsweise einen Trainingseingang für das vorgegebene Gegenstandsfeststellungssignal auf. Darüber wird dem Sensor während einer oder jedenfalls in zuordenbarem Zusammenhang zu einer Detektionssituation von außen das zugehörige Gegenstandsfeststellungssignal vorgegeben. Dabei handelt es sich bevorzugt um einen physischen eigenen Eingang oder Pin, der entsprechend dem binären Gegenstandsfeststellungssignal zwei Zustände einnehmen kann. Allerdings kann dieser Eingang mit einer Leitung verbunden sein, die im Betrieb eine ganz andere Funktion hat, die möglicherweise auch schon in herkömmlichen Sensoren vorhanden war. Denkbar ist auch, den Trainingseingang als Befehl in einem Schnittstellenprotokoll wie IO-Link zu implementieren. Der Trainingseingang ist keine Teachtaste, denn darüber wird kein Gegenstandsfeststellungssignal vorgegeben, sondern lediglich der Einlernvorgang ausgelöst. Ein erfindungsgemäßer Sensor könnte jedoch zusätzlich eine Teachtaste aufweisen, wobei der Einlernvorgang ebenso über eine bestimmte Signalfolge auf dem Trainingseingang oder einem anderen Eingang gestartet werden kann.

Das vorgegebene Gegenstandsfeststellungssignal erzeugt erfindungsgemäß mindestens ein zusätzlicher Sensor. Der zusätzliche Sensor bewertet die Detektionssituationen der Einlernphase und gibt diese Bewertung dem erfindungsgemäßen Sensor vor. Der zusätzliche Sensor ist insbesondere nur vorübergehend während der Einlernphase vorgesehen.

Danach kann der zusätzliche Sensor wieder entfernt werden. Der zusätzliche Sensor beansprucht also im Betrieb keinen Platz und keine Wartung, muss auch gar nicht mit erworben werden, sondern kann nacheinander für eine Vielzahl von Einlernphasen an unterschiedlichen Orten oder sogar in einer eigenen Anwendung benutzt werden. Alternativ bleibt der zusätzliche Sensor auch nach der Einlernphase montiert, ist dann aber ausgeschaltet, beziehungsweise sein Signal wird von dem erfindungsgemäßen Sensor außerhalb der Einlernphase nicht mehr beachtet.

Während der Einlernphase ist vorzugsweise mindestens ein die Erfassung eines Sensorsignals veränderndes Objekt in dem Überwachungsbereich angeordnet. Das Objekt dient als Hilfsmittel für die Einlernphase. Das Objekt befindet sich zumindest zeitweise oder über die gesamte Einlernphase im Überwachungsbereich, vorzugsweise nur vorübergehend, wird also nach der Einlernphase wieder entfernt. Das Objekt kann das Sensorsignal des Sensors selbst beeinflussen und beispielsweise die Objekterfassung verbessern. Das ist nicht immer günstig, weil sich dann die Detektionssituation vom eigentlichen Betrieb unterscheidet. Vorzugsweise beeinflusst daher das Objekt das Sensorsignal des zusätzlichen Sensors, und dies auf eine Weise, die der erfindungsgemäße Sensor nicht wahrnimmt. Beispiele für optische zusätzliche Sensoren sind Klebebänder mit Schwarz-Weiß-Kontrasten, Farben, Reflektoren oder polarisierenden Eigenschaften auf den zu erfassenden Objekten oder dem Hintergrund, für induktive, kapazitive oder magnetische Sensoren wären entsprechend leitende oder magnetische Objekte denkbar.

Ein Schaltausgang des zusätzlichen Sensors ist bevorzugt an den Trainingseingang angeschlossen. Somit wird der zusätzliche Sensor direkt zum Lehrer des erfindungsgemäßen Sensors. Der Benutzer muss dann während der Einlernphase an den Sensoren nichts mehr verändern und nur noch dafür sorgen, dass die Detektionssituationen verwirklicht werden, also beispielsweise die Anlage starten. Das Einlernen läuft dann von selbst (Autoteach).

Der zusätzliche Sensor erfasst bevorzugt ein anderes Sensorsignal als der Sensor und/oder wertet das Sensorsignal auf andere Weise aus. Damit sind ein anderes Sensorprinzip oder zumindest eine Variation von einem Parameter der Sensorerfassung gemeint. Dasselbe Sensorsignal könnten zwei Sensoren ohnehin nicht erfassen. Der erfindungsgemäße Sensor und der zusätzliche Sensor sind also in zumindest einer Eigenschaft diversitär, wie eine Lichtschranke zu einem Lichttaster oder unzählige andere Kombinationsmöglichkeiten. Dies kombiniert sich besonders vorteilhaft mit einem bereits erläuterten Hilfsobjekt im Überwachungsbereich, welches die Erfassung des zusätzlichen Sensors unterstützt. Beispielhafte zusätzliche Sensoren sind ein Kontrasttaster mit farbigen Klebestreifen, ein Codeleser mit Codierungen und vieles mehr.

Der zusätzliche Sensor basiert vorzugsweise auf einem komplexeren und/oder anfälligeren Sensorprinzip als der Sensor. Ein solcher zusätzlicher Sensor könnte die Anwendung möglicherweise auch lösen, wäre aber zu teuer beziehungsweise zu kurzlebig. Denkbar ist auch, dass der zusätzliche Sensor zwar zuverlässig das gewünschte Gegenstandsfeststellungssignal ableiten kann, aber in anderer Hinsicht den erfindungsgemäßen Sensor nicht ersetzen könnte, beispielsweise aufgrund seiner Baugröße oder Ansprechzeit. Beispiele sind Kameras mit aufwändigen Bildauswertungsalgorithmen oder schnell verschleißende taktile Sensoren.

Der zusätzliche Sensor ist bevorzugt in einer Position und/oder auf eine Weise angeordnet, die keiner für den Sensor während des Betriebs möglichen Position und/oder Weise entspricht. Die Montage des zusätzlichen Sensors ist also nur vorübergehend während der Einlernphase möglich. Beispielsweise werden Anschlussleitungen des zusätzlichen Sensors auf eine Weise geführt, die für den Alltagsbetrieb nicht robust genug sind, oder provisorische Tragekonstruktionen für den Sensor oder dessen Anschlüsse verwendet. Zu denken wäre auch daran, dass die gewünschte Erfassungsposition des zusätzlichen Sensors im Betrieb nicht verfügbar ist, etwa weil der zusätzliche Sensor von der Seite erfasst, dies aber im Betrieb die Abläufe stören würde und deshalb für den erfindungsgemäßen Sensor nur eine Montageposition von oben möglich ist.

Vorzugsweise wird aus den in der Einlernphase erfassten Sensorsignalen mindestens ein ein- oder mehrdimensionales Histogramm gebildet und der Schaltpunkt aus dem Histogramm abgeleitet. Nochmals bevorzugt handelt es sich um zwei Histogramme, nämlich je eines für beide Möglichkeiten des vorgegebenen binären Gegenstandsfeststellungssignals. Das Histogramm bereitet das Sensorsignal in einer Weise auf, die das Ableiten eines Schaltpunkts unter einfacher Berücksichtigung der diversen Detektionssituationen ermöglicht. In einem eindimensionalen Beispiel werden die Häufigkeiten der gemessenen Pegel des Sensorsignals während der unterschiedlichen Detektionssituationen in einem Histogramm gesammelt. Wie schon erwähnt, kann das Sensorsignal auch mehrdimensional sein, und dann ist es sinnvoll, ein mehrdimensionales Histogramm zu bilden. Die mehreren Dimensionen können dasselbe Sensorelement betreffen, etwa Pegel und Phase oder Mittelwert und Varianz. Alternativ oder zusätzlich werden mehrere Messergebnisse erfasst, etwa zwei Empfangselemente oder sogar zahlreiche Pixel eines Bildsensors, oder ein Lichtsignal und ein Signal eines induktiven Sensorelements.

Der Schaltpunkt weist bevorzugt mindestens eine Schwelle oder eine Grenzkurve auf. Eine Schwelle ist ein sehr einfaches und bewährtes Kriterium insbesondere für ein eindimensionales Sensorsignal. Sie kann beispielsweise zwischen Maxima eines Histogramms gelegt werden. Mehrere Schwellen und/oder Hysteresen sind denkbar. Im n-dimensionalen Fall entspricht eine Schwelle einer n-1-dimensionalen Grenzkurve, insbesondere Ebene beziehungsweise Hyperebene, welche in einem n-dimensionalen Histogramm Cluster von mit gleichem Gegenstandsfeststellungssignal bewerteten Sensorsignalen trennt.

Der Schaltpunkt weist bevorzugt einen Klassifikator auf. Gerade bei hochdimensionalen Sensorsignalen, wie von den Pixeln eines Bildsensors, ist es manchmal nicht mehr praktikabel, ein geometrisches Gebilde als Schaltpunkt zu definieren, welches die Zustände des Gegenstandsfeststellungssignals hinreichend eindeutig und robust trennt. Dann ist es sinnvoll, einen Klassifikator einzusetzen, der den Sensorsignalen ein Gegenstandsfeststellungssignal zuordnet. Der Klassifikator kann ein klassischer oder deterministischer Klassifikator sein, der in der Einlernphase parametriert wird. Besonders bevorzugt handelt es sich um einen Klassifikator nach einem Verfahren des maschinellen Lernens. Hier sind allgemein alle Verfahren möglich, die durch die gelabelten Trainingsdaten der Einlernphase trainiert werden können, insbesondere einfache oder auch größere künstliche neuronale Netze (CNN, Deep Learning).

Der Sensor ist in einem nicht-erfindunggemäßen Beispiel während und/oder nach der Einlernphase an eine übergeordnete Recheneinheit angeschlossen, insbesondere einen Server oder einer Cloud, und der Schaltpunkt wird in der Recheneinheit bestimmt und an die Auswertungseinheit zurückgegeben. In einem derartigen nicht-erfindunggemäßen Beispiel werden die Trainingsdaten aus der Einlernphase, d.h. die mit dem zugehörigen vorgegebenen Gegenstandsfeststellungssignal gelabelten Sensorsignale, an die Recheneinheit übergeben. Dort wird der Schaltpunkt abgeleitet, was unter Umständen sehr zeit- und rechenintensiv ist. Der Schaltpunkt wird an den Sensor zurückgespielt, etwa in Form von mindestens einer Schwelle, einer Grenzkurve oder den Gewichtungsfaktoren oder allgemeiner einer Beschreibungsdatei eines fertig trainierten neuronalen Netzes. Der Sensor kann dadurch einfach bleiben, die nur in der Einlernphase notwendigen großen Rechenkapazitäten werden von außen (remote) zur Verfügung gestellt. Es ist in einem weiteren nicht-erfindunggemäßen Beispiel auch vorstellbar, anstelle der bereits gelabelten Sensorsignale nur die Sensorsignale selbst an die Recheneinheit zu übergegen. Die Bewertung, also das Labeling, findet dann erst in der Recheneinheit statt. Beispielsweise sind dazu mächtige Auswertungen in der Recheneinheit verfügbar, welche die Sensorsignale bewerten und weit über die Möglichkeiten des Sensors selbst hinausgehen. Außerdem könnte der zusätzliche Sensor in einem weiteren nicht-erfindunggemäßen Beispiel an der Recheneinheit statt an dem Sensor angeschlossen sein, um so die Bewertung vorzunehmen oder zu unterstützen. Die richtige Zuordnung lässt sich durch eine simultane Übertragung von Sensorsignalen des erfindungsgemäßen Sensors und des zusätzlichen Sensors sicherstellen, aber auch durch asynchrone Übertragung von Sensorsignalen, die dafür mit Zeitstempeln oder dergleichen versehen sind.

Der Sensor ist bevorzugt eine Lichtschranke oder ein Lichttaster. Das ist ein häufig eingesetzter, einfacher und bewährter schaltender Sensor, der von dem deutlich verbesserten Einstellen des Schaltpunktes besonders profitiert. Die Lichtschranke kann eine Einweg- oder eine Reflexionslichtschranke sein, der Lichttaster über eine Hintergrundausblendung oder eine Entfernungsmessung durch ein Lichtlaufzeitverfahren oder Triangulation verfügen. Alternativ kann es sich bei dem Sensor um einen induktiven, kapazitiven, magnetischen, Ultraschall- oder Radarsensor handeln.

Der Sensor weist bevorzugt eine Vielzahl von Sensorelementen mit unterschiedlichen Eigenschaften auf. Beispielsweise ist ein Sendeelement eines optoelektronischen Sensors in seiner Wellenlänge umschaltbar, oder es sind mehrere Sende- und gegebenenfalls auch Empfangselemente vorgesehen. Der Sensor kann in der Lage sein, zusätzliche Größen wie Druck, Temperatur oder Schall zu erfassen, ohne dass dies zunächst speziell an eine Anwendung angepasst ist. Ein solcher Multisensor ist entweder von Anfang an dafür gedacht, diverse Messgrößen zu erfassen, oder es ist schon weiterhin ein Hauptprinzip wie optische Erfassung vorgesehen, jedoch besteht gleichzeitig die Möglichkeit, physikalische Randbedingungen durch Hilfssensoren zu messen. Dann werden in der Einlernphase die diversen Sensorsignale des Multisensors gesammelt und auf eine der erläuterten Weisen bewertet, ihnen also ein Gegenstandsfeststellungssignal zugeordnet. Vorzugsweise extern wird dieser Trainingsdatensatz genutzt, um einen Schaltpunkt abzuleiten. Der Sensor wird auf diese Weise mit einer an sich einfachen eigenen Auswertung - eine oder mehrere Schwellen genügen in vielen Fällen, und auch ein trainiertes neuronales Netz beansprucht relativ wenig Ressourcen -durch nur temporär beispielsweise über eine Cloud zur Verfügung gestellte, um Größenordnungen mächtigere Intelligenz für unterschiedlichste Anwendungen einsetzbar.

Das erfindungsgemäße Verfahren kann auf ähnliche Weise weitergebildet werden und zeigt dabei ähnliche Vorteile. Derartige vorteilhafte Merkmale sind beispielhaft, aber nicht abschließend in den sich an die unabhängigen Ansprüche anschließenden Unteransprüchen beschrieben.

Die Erfindung wird nachstehend auch hinsichtlich weiterer Merkmale und Vorteile beispielhaft anhand von Ausführungsformen und unter Bezug auf die beigefügte Zeichnung näher erläutert. Die Abbildungen der Zeichnung zeigen in:
- Fig. 1: eine schematische Schnittansicht eines Sensors des erfindungsgemäßen Systems;
- Fig. 2: eine Darstellung einer Anwendung des erfindungsgemäßen Systems an einem Förderband mit dem zusätzlichen Sensor, welcher ein Gegenstandsfeststellungssignal vorgibt;
- Fig. 3: eine Darstellung ähnlich Figur 3, jedoch mit anderen zu detektierenden Objekten und einem anderen zusätzlichen Sensor in anderer Position;
- Fig. 4: eine schematische Darstellung eines eindimensionalen Histogramms bewerteter Sensorsignale und ein möglicher daraus abgeleiteter Schaltpunkt; und
- Fig. 5: eine schematische Darstellung ähnlich Figur 4 für ein zweidimensionales Beispiel.

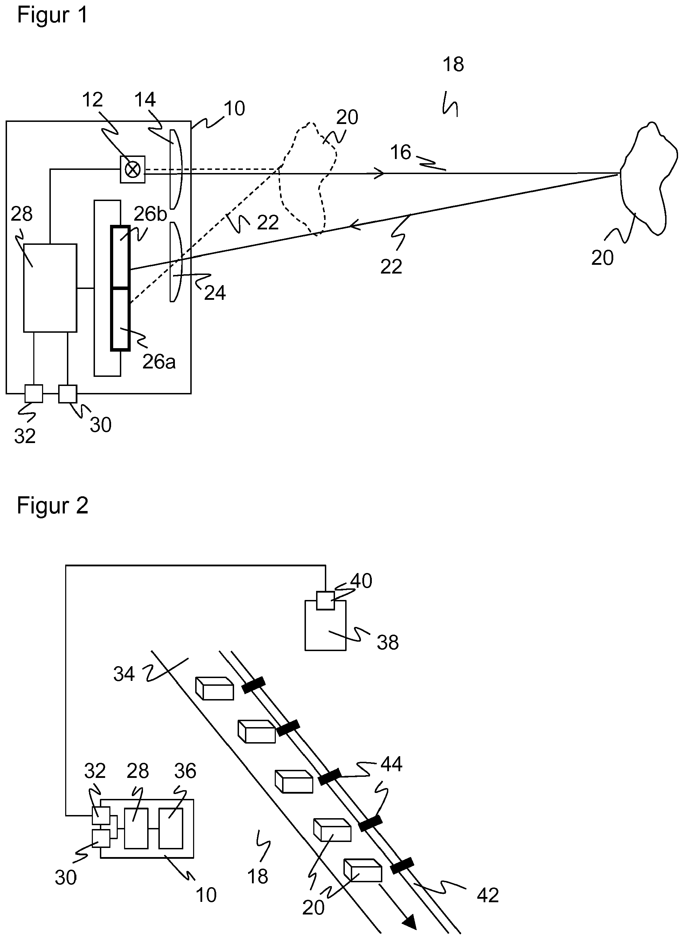

Figur 1 zeigt eine schematische Schnittdarstellung eines Sensors 10 in einer Ausführung als herkömmlicher Triangulations-Lichttaster mit Hintergrundausblendung. Dies ist nur eines von zahlreichen Ausführungsformen eines erfindungsgemäßen Sensors 10, an dem rein beispielhaft erläutert werden soll, wie ein Sensor 10 mittels eines einstellbaren Schaltpunkts ein Gegenstandsfeststellungssignal erfasst. Die Erfindung umfasst allgemein Sensoren, die ein binäres Gegenstandsfeststellungssignal liefern, wie Reflexionslichtschranken, Einweglichtschranken oder entfernungsmessende Lichttaster nach dem Prinzip des Lichtlaufzeitverfahrens oder der Triangulation, aber auch induktive, kapazitive, magnetische, Ultraschall- oder Radarsensoren und weitere.

In der Ausführungsform des Sensors 10 nach Figur 1 sendet ein Lichtsender 12 über eine strahlformenden Sendeoptik 14 einen Lichtstrahl 16 in einen Überwachungsbereich 18 aus. Fällt der Lichtstrahl 16 auf ein Objekt 20, so gelangt ein Teil des Sendelichts als remittierter oder reflektierter Sendelichtstrahl 22 zurück zu dem Sensor 10. Eine Empfangsoptik 24 fängt diesen remittierten Sendelichtstrahl 22 auf und leitet ihn auf einen Lichtempfänger 26, wo das einfallende Licht in ein elektrisches Empfangssignal umgewandelt wird. Eine Auswertungseinheit 28 ist mit dem Lichtempfänger 26 verbunden, um aus den elektrischen Empfangssignalen je nach Anwesenheit eines Objekts 20 ein Gegenstandsfeststellungssignal zu bestimmen, das an einem Schaltausgang 30 ausgegeben wird.

Der Sensor 10 verfügt über eine Hintergrundausblendung. Der Lichtempfänger 26 ist in ein Nahbereichselement 26a und ein Fernbereichselement 26b unterteilt. Aufgrund des Versatzes zwischen Lichtsender 12 mit Sendeoptik 14 gegenüber dem Lichtempfänger 26 mit Empfangsoptik 24 und wegen der Anordnung der beiden Empfangselemente 26ab längs der Querverbindung zwischen Lichtsender 12 und Lichtempfänger 26 fällt der remittierte Lichtstrahl 22 eines mit gestrichelten Linien dargestellten nahen Objekts 20 auf das Nahbereichselement 26a und der remittierte Lichtstrahl 22 eines mit durchgezogenen Linien dargestellten fernen Objekts 20 auf das Fernbereichselement 26b. Die Auswertungseinheit 28 bildet zur Hintergrundausblendung die Differenz zwischen dem Signal des Nahbereichselements 26a und des Fernbereichselements 26b und bewertet diese Differenz mit einer Schwelle.

Der Schaltpunkt des Sensors 10 bestimmt, welche Abstände der Sensor 10 als Hintergrund ansehen und ausblenden soll. Das lässt sich mechanisch über eine justierbare Linsenposition, alternativ durch variables Zusammenfassen von Pixeln eines Zeilensensors zu Nah- und Fernbereichselement 26a-b und in gewissem Rahmen auch über die Schwelle einstellen. Es ist auch denkbar, die Pixelsignale eines Zeilensensors nicht direkt zu summieren, sondern zunächst einzeln zu behandeln.

Für die Anwendung des Sensors 10 muss der Schaltpunkt passend eingestellt sein, damit nur die richtigen Objekte erfasst werden und es nicht beispielsweise zu Verwechslungen mit Hintergrundobjekten kommt oder Objekte fälschlich ausgeblendet und damit übersehen werden. Dazu werden erfindungsgemäß dem Sensor 10 in einer Einlernphase zahlreiche Detektionssituationen mit und ohne zu erfassendes Objekt präsentiert. Diese Detektionssituationen werden von außen bewertet, wofür es verschiedenste noch zu beschreibende Möglichkeiten gibt. Es wird also von außen festgelegt, ob in der jeweiligen Detektionssituation das Objekt erfasst werden soll oder nicht, beziehungsweise das gewünschte Gegenstandsfeststellungssignal vorgegeben.

Der Sensor 10 gemäß Figur 1 weist einen Trainingseingang 32 für das von außen vorgegebene Gegenstandsfeststellungssignal auf. Das kann ein dedizierter zusätzlicher Eingang sein. In manchen herkömmlichen Sensoren ist ohnehin schon eine geeignete Steuerleitung an der elektrischen Schnittstelle vorhanden, die bisher zum testweisen Abschalten des Lichtsenders 12, zur Hell-Dunkel-Umschaltung oder zum Auslösen eines Teachvorgangs benutzt wurde. Diese Steuerleitung kann in einer bevorzugten Ausführungsform während der erfindungsgemäßen Einlernphase für den Trainingseingang 32 genutzt werden.

Während der Einlern- oder Trainingsphase zum Einstellen des Schaltpunktes werden nun dem Sensor 10 alle gewünschten Objekte in den später relevanten Variationen durch den Strahlengang vorgeführt. Das können künstlich gestellte Detektionssituationen sein, am einfachsten ist es aber, die spätere Anwendung zu beobachten und dafür beispielsweise die Anlage in Gang zu setzen, in welcher der Sensor 10 montiert ist. Parallel dazu wird über den Trainingseingang 32 das zugehörige gewünschte Gegenstandsfeststellungssignal eingespeist. Danach kann der Sensor 10 eigenständig seinen Schaltpunkt passend einstellen.

Die Einlernphase umfasst somit drei Bausteine: Erfassen von Sensorsignalen der jeweiligen Detektionssituationen, Bewerten der Detektionssituation durch Vorgeben eines gewünschten Gegenstandsfeststellungssignals und schließlich Ableiten eines Schaltpunkts. Der erste Schritt erfolgt erfindungsgemäß zwingend durch den Sensor 10 selbst. Den dabei erfassten Sensorsignalen wird erfindungsgemäß extern ein gewünschtes Gegenstandsfeststellungssignal zugeordnet. Das abschließende Ableiten eines Schaltpunkts findet erfindungsgemäß in der eigenen Auswertungseinheit 28 des Sensors 10 oder in einem nicht-erfindungsgemäßen Beispiel extern statt. Nach Abschluss der Einlernphase hat die Auswertungseinheit 28 den Schaltpunkt entweder erfindunggemäß selbst gefunden, oder in einem nicht-erfindunggemäßen Beispiel die erforderlichen Daten für den Schaltpunkt, wie Schwellen oder Parameter und Gewichte eines Klassifikators oder neuronalen Netzes, werden für den nachfolgenden eigentlichen Betrieb an die Auswertungseinheit 28 zurückgespielt.

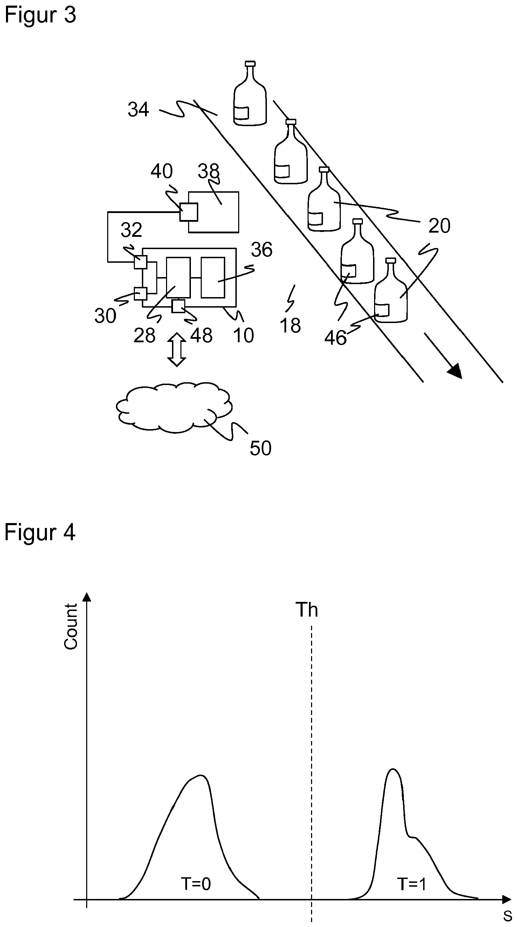

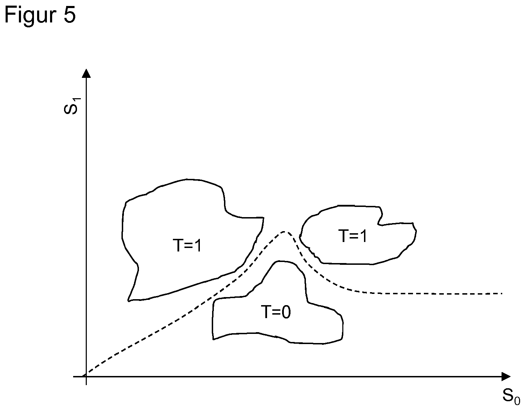

Die Erfassung von Sensorsignalen wurde am Beispiel des Sensors 10 gemäß Figur 1 bereits erläutert. Nachfolgend wird zunächst unter Bezugnahme auf die Figuren 2 und 3 der zweite Schritt erläutert, nämlich wie sich geeignet ein gewünschtes Gegenstandsfeststellungssignal erzeugen lässt, was unter anderem vom Sensor 10, den Eigenschaften der zu detektierenden Objekte und Randbedingungen der Anwendung abhängen kann. Danach wird unter Bezugnahme auf die Figuren 4 und 5 auf den abschließenden Schritt eingegangen, aus den Sensorsignalen und den zugehörigen gewünschten Gegenstandsfeststellungssignalen einen geeigneten Schaltpunkt abzuleiten.

Figur 2 illustriert eine beispielhafte Anwendung des Sensors 10 zur Detektion in diesem Falle flacher Objekte 20 auf einem Förderband 34. Die eigentliche Sensorik des Sensors 10 ist hier zusammenfassend als Sensorelement 36 dargestellt. Das unterstreicht auch noch einmal, dass die Erfindung auf keinen konkreten Sensoraufbau, nicht einmal Sensortyp oder physikalisches Sensorprinzip beschränkt ist. Das Sensorsignal ist dementsprechend von dem Empfangssignal eines Lichtempfängers 26 verallgemeinert und kann mehrdimensional werden, wenn der Sensor 10 mehrere Messgrößen liefert.

Ein zusätzlicher Sensor 38 ist mit seinem Schaltausgang 40 an den Trainingseingang 32 des Sensors 10 angeschlossen. Auf diese Weise gibt der zusätzliche Sensor 38 während der Einlernphase das gewünschte Gegenstandsfeststellungssignal vor. Alternativ zu einer Verbindungsleitung zwischen Schaltausgang 40 und Trainingseingang 32 sind auch andere Kommunikationswege denkbar, beispielsweise Befehle innerhalb eines Protokolls wie IO-Link oder sogar eine Drahtlosverbindung.

In diesem Beispiel ist der zusätzliche Sensor 38 ein Kontrasttaster. Um diesem Kontrasttaster die Aufgabe zu erleichtern, ist auf dem Förderband 34 eine durchgehende helle Spur mit Klebeband 42 gekennzeichnet. Die Objekte 20 sind äquidistant oder in sonstiger, vorzugsweise dem üblichen Betrieb entsprechender Weise auf dem Förderband 34 angeordnet. Die Positionen der Objekte 20 sind mit zusätzlichem dunklem Klebeband 44 markiert. Der als Kontrasttaster ausgebildete zusätzliche Sensor 38 erkennt daher sehr zuverlässig, wann sich jeweils ein Objekt 20 im Überwachungsbereich 18 des Sensors 10 befindet, und gibt dem Sensor 10 das entsprechende Gegenstandsfeststellungssignal über den Schaltausgang 40 und den Trainingseingang 32 vor.

Ein von oben montierter Kontrasttaster ist nur eines von vielen Beispielen eines zusätzlichen Sensors 38. So ist zunächst nicht unbedingt erforderlich, den zusätzlichen Sensor 38 durch Hilfsmittel wie das Klebeband 42, 44 zu unterstützen. Weiterhin können natürlich auch andere zusätzliche Sensoren 38 und/oder Hilfsmittel zum Einsatz kommen, etwa indem Objektpositionen mit Codes markiert und durch einen Codeleser als zusätzlichen Sensor 38 erfasst werden. Es ist aber vorteilhaft, wenn der zusätzliche Sensor 38 sich in seiner Funktionsweise und/oder Arbeitsposition deutlich von dem Sensor 10 unterscheidet und dadurch in die Lage versetzt ist, zuverlässige Bewertungen und damit gewünschte Gegenstandsfeststellungssignale zu erzeugen.

Ein weiteres konkretes Beispiel ohne eigene Darstellung ist die Gassenförderung, wo Objekte in mehreren parallelen Gassen gefördert werden und unabhängig von oben durch den Sensor 10 oder mehrere derartige Sensoren 10 erkannt werden sollen. Technisch wäre es hier viel einfacher und robuster, die Objekte seitlich mit einer Einweglichtschranke zu erfassen. Diese Montage ist aber bei der Gassenförderung insbesondere für einzelne Gassen unpraktisch oder sogar unmöglich. Provisorisch kann aber eine Einweglichtschranke als zusätzlicher Sensor 38 in die Gasse eingeklebt und deren Anschlussleitung frei durch die Luft verlegt werden. Gibt es keine Trennwand zwischen den Gassen, an denen die Einweglichtschranke angebracht werden kann, so gibt es die Möglichkeit, bewegliche Ärmchen als Halterungen zu verwenden. Alternativ wird die Einweglichtschranke über alle Gassen montiert und künstlich dafür gesorgt, dass sich während der Einlernphase Objekte nur auf jeweils einer einzigen zu trainierenden Gasse befinden. Mit Hilfe der Einweglichtschranke wird nun in einer Einlernphase der Sensor 10 für die jeweiligen Gassen trainiert, insbesondere indem der Schaltausgang der Einweglichtschranke an den Trainingseingang 32 angeschlossen wird. Danach ist der Sensor 10 in der Lage, die Anwendung auch in der Montage von oben zu lösen, wofür im Übrigen eine Einweglichtschranke völlig ungeeignet wäre. Die als zusätzlicher Sensor 38 eingesetzte Einweglichtschranke kann nach Abschluss der Einlernphase wieder entfernt werden, um den weiteren Betrieb nicht zu stören. Sie kann sogar nur für das Einrichten geliehen und anschließend vom Mitarbeiter des Herstellers mitgenommen oder an den Hersteller zurückgeschickt werden.

Figur 3 illustriert eine weitere beispielhafte Anwendung des Sensors 10 zur Detektion transparenter Flaschen als Objekte 20 auf einem Förderband 34. Das Problem bei der Erfassung transparenter Objekte ist, dass ein guter Teil des Sendelichts das Objekt durchdringt und damit verloren geht oder später aus dem Hintergrund und damit einer anderen Entfernung zurückkommt. Außerdem haben gerade Flaschen außer Transparenz- auch noch Glanz- und Linseneigenschaften. Erfindungsgemäß können die Flaschen während der Einlernphase mit einem Etikett oder einer Banderole 46 aus Reflektorfolie versehen werden. Damit könnte schon der Sensor 10 selbst verlässlicher detektieren. In diesem Sinne gibt dann die Banderole 46 das Gegenstandsfeststellungssignal vor.

Allerdings ist es erfindungsgemäß sogar bevorzugt, wenn sich die Banderole 46 gerade nicht im Überwachungsbereich 18 des Sensors 10 befindet, damit der Sensor 10 in der Einlernphase keine gegenüber dem späteren Betrieb ohne Banderole 46 verfälschten Sensorsignale erfasst. Dazu kann die Banderole 46 abweichend von Figur 3 auf der jeweiligen Rückseite der Flasche angebracht sein. Das gewünschte Gegenstandsfeststellungssignal erzeugt ein einfacher Reflexionstaster, der in diesem Beispiel als zusätzlicher Sensor 38 fungiert, die Banderole 46 sicher erfasst und dies über seinen Schaltausgang 40 an den Trainingseingang 32 übermittelt.

Der in Figur 3 dargestellte Sensor 10 weist zudem eine drahtgebundene oder drahtlose Kommunikationsschnittstelle 48 auf, über die eine Verbindung zu einer Cloud 50 hergestellt werden kann. Die Cloud 50 steht stellvertretend für eine weitere Recheneinheit mit gegenüber dem Sensor 10 überlegenen Rechenkapazitäten. Der Sensor 10 erzeugt in diesem nicht-erfindungsgemäßen Beispiel nur gelabelte Trainingsdaten, nämlich die Sensorsignale in den jeweiligen Detektionssituationen und die zugehörigen von dem zusätzlichen Sensor 38 vorgegebenen Gegenstandsfeststellungssignale. Der Schaltpunkt wird dann nicht von der Auswertungseinheit 28 selbst, sondern extern in der Cloud 50 bestimmt und anschließend der Auswertungseinheit 28 zur Verwendung im Betrieb zurückgegeben.

Die Frage, welche Schritte der Einlernphase in der Auswertungseinheit 28 selbst oder extern beispielsweise in der Cloud 50 durchgeführt werden, ist unabhängig davon, wie das jeweilige Sensorsignal und gewünschte Gegenstandsfeststellungssignal erzeugt wird. Insbesondere wäre in einem nicht-erfindungsgemäßen Beispiel eine entsprechende Auslagerung in eine Cloud 50 auch sonst, etwa für die zu Figur 2 erläuterten Ausführungsbeispiele möglich, oder im Beispiel der Figur 3 findet dies doch erfindungsgemäß in der Auswertungseinheit 28 statt, ohne dass der Sensor 10 eine Kommunikationsschnittstelle 48 und Cloud 50 nutzt.

Es wäre in einem weiteren nicht-erfindungsgemäßen Beispiel denkbar, den zusätzlichen Sensor 38 in Figur 3 wegzulassen. Die Banderolen 46 können alternativ als Codierungen ausgestaltet werden. Der Sensor 10 erfasst die wechselnde Intensität der Codierung in seinem Sensorsignal, kann sie aber selbst nicht interpretieren. Vielmehr wird das Sensorsignal nach eventueller Zwischenpufferung an die Cloud 50 übergeben. Dort wird der Code gelesen, das Sensorsignal mit den Codeinhalten und den Lücken, in denen keine Codes gelesen werden können, zu einem gelabelten Testdatenset verknüpft, daraus ein Schaltpunkt abgeleitet und dieser dem Sensor 10 übergeben.

Den anhand der Figuren 2 und 3 beschriebenen beispielhaften Möglichkeiten, ein Gegenstandsfeststellungssignal vorzugeben, liegt die gemeinsame Idee zugrunde, in der Einlernphase zusätzlich zum eigenen Sensorsignal des Sensors 10 weitere Informationen oder zumindest Auswertungskapazitäten zu nutzen, dies aber nur vorübergehend. Insbesondere wird durch mechanischen oder elektronischen Zusatzaufwand oder durch sehr teure oder schnell verschleißende Sensorik ein sehr verlässliches Gegenstandsfeststellungssignal erzeugt. Sobald damit Trainingsdaten zum Einlernen des Sensors 10 gewonnen sind, kann der Zusatzaufwand wieder entfernt werden. Die derart erstellte Konfiguration des eingelernten Sensors 10 lässt sich auch auf weitere Sensoren duplizieren. Das Einlernen muss daher nur einmal prototypisch erfolgen und für alle vergleichbaren oder identischen Applikationen reproduzieren.

Liegt nun, wie vorstehend in einigen, bei Weitem nicht abschließenden Beispielen geschildert, ein Trainingsdatensatz aus Sensorsignalen mit gewünschten zugehörigen Gegenstandsfeststellungssignalen vor, so wird als abschließender Schritt der Einlernphase der Sensor 10 damit trainiert, nämlich ein Schaltpunkt abgeleitet. Weiterhin bedeutet Schaltpunkt diejenige Zuordnungsvorschrift oder denjenigen Klassifikator, mit dem einem auch hochdimensionalen Sensorsignal möglicherweise unter auch hochkomplexen Randbedingungen ein binäres Gegenstandsfeststellungssignal zugewiesen wird. Erfindungsgemäß erfolgt dies in der Auswertungseinheit 28 oder in einem nicht-erfindungsgemäßen Beispiel extern, etwa in der Cloud 50.

Das Vorgehen hängt von der Anzahl zur Verfügung stehender paralleler Messinformationen, d.h. der Dimension des Sensorsignals, und den zu berücksichtigenden Randbedingungen ab. In vielen Fällen ist eine kontinuierliche oder diskrete Funktion *f* für das Gegenstandsfeststellungssignal *Q* in Abhängigkeit von dem Sensorsignal *S* gesucht, wobei die Struktur der Funktion f auch vorgegeben sein kann und noch parametriert werden muss: *Q* = *f*(*S*).

Figur 4 illustriert das Ableiten des Schaltpunktes für einen einfachen eindimensionalen Fall. In diesem Ausführungsbeispiel wird eine Schwelle *Th* gesucht, um den Schaltpunkt *Q* = *sgn*(*S* - *Th*) zu parametrieren. Dafür wird ein Histogramm des Sensorsignals gebildet, um festzustellen, wie sich das Sensorsignal in den Detektionssituationen der Einlernphase verteilt, insbesondere wo sich ein bestimmter Zustand des vorgegebenen Gegenstandsfeststellungsignals häuft oder gar nicht auftritt. Besonders vorteilhaft ist es, wenn zwei solche Histogramme gebildet werden, nämlich je eines für beide binären Zustände des vorgegebenen Gegenstandfeststellungssignals *T.*

Das Beispiel in Figur 4 zeigt ein solches doppeltes Histogramm. Es zeigen sich zwei klare Häufungen oder Peaks für die Zustände *T* = 0 und *T* = 1 mit einem Zwischenbereich, in den die gesuchte Schaltschwelle *Th* gelegt werden kann. Dieses anschauliche Vorgehen ist mathematisch eine Optimierungsaufgabe, bei der die Schaltschwelle *Th* so gesetzt wird, dass der Abstand zwischen der Schwelle und jedem Datenpunkt möglichst groß wird.

Die Darstellung der Figur 4 mit eindeutiger Trennung zwischen den Zuständen *T* = 0 und *T* = 1 ist nicht idealisiert, sondern realistisch. Allerdings könnte in schwierigen Anwendungen die Trennung beziehungsweise der Abstand zwischen den beiden Peaks weniger deutlich ausfallen. Darüber hinaus sind einzelne Ausreißer in die Region des jeweils anderen Zustands *T* auch nicht ganz unmöglich, die dann durch Doppelbins mit unterschiedlichen Farben oder Schraffuren illustriert werden könnten. Bei einer Schaltschwelle bleibt wenig anderes übrig, als solche Ausreißer zu ignorieren. Für komplexere Schaltpunkte wäre auch ein anderer Umgang denkbar, um Fehler erster und zweiter Art (Schalten auf tatsächlich nicht vorhandenes Objekt beziehungsweise übersehenes Objekt) gegeneinander abzuwägen.

Figur 5 illustriert ein weiteres Beispiel für ein zweidimensionales Sensorsignal (*S*₀, *S*₁). Dieses Sensorsignal kann zwei Komponenten desselben physikalischen Signals umfassen, etwa den Pegel und die Phase, oder es stammt aus zwei Quellen wie dem Nah- und dem Fernbereichselement 26a-b oder auch zwei ganz unterschiedlichen Sensorelementen, wie einem induktiven Sensor und einem Lichttaster. Die Häufigkeit in den einzelnen Bins wird jetzt in der Z-Achse aufgetragen, wobei das dargestellte Beispiel nur die Umrisse von überhaupt belegten Bins ohne deren Höhe zeigt. In manchen Fällen kann die einfache Schwelle *Th* des eindimensionalen Falles durch eine oder mehrere Geraden ersetzt werden. Allgemein ist wie auch im Beispielfall eine Kurve erforderlich. Das Optimierungsproblem, mit dem diese Kurve bestimmt wird, ist ein wenig komplexer als im eindimensionalen Fall, das Grundprinzip und das Ziel einer robusten Trennung mit möglichst großem Abstand zu den aufgetretenen Sensorsignalen des jeweiligen Zustands *T* ist das gleiche.

Ein entsprechendes n-dimensionales Histogramm lässt sich auch bei höherdimensionalen Sensorsignalen erzeugen, wie von einem Mehrfachsensor mit mehreren Erfassungsgrößen oder einen mehrfach unterteilten Lichtempfänger. Die Kurve wird dann zu einer verallgemeinerten Grenzkurve, nämlich einer n-1-dimensionalen Untermannigfaltigkeit beziehungsweise einer flachen oder gekrümmten Hyperebene.

Für hochdimensionale Sensorsignale beispielsweise eines Multisensors mit zahlreichen Messverfahren oder einen Bildsensor mit vielen Pixeln wird der Histogrammansatz zunehmend unpraktikabel, weil es immer komplexer wird, eine trennscharfe verallgemeinerte Grenzkurve zu finden. Dann können bekannte Verfahren beispielsweise der Bildverarbeitung oder allgemeine Klassifikatoren eingesetzt werden.

Insbesondere wird ein Klassifikator genutzt, der auf maschinellem Lernen basiert, vorzugsweise ein künstliches neuronales Netz. Mit den Sensorsignalen und den zugehörigen gewünschten Gegenstandsfeststellungssignalen wird auf eine automatisierte Weise ein durch die Länge der Einlernphase skalierbarer, bereits gelabelter Trainingsdatensatz zur Verfügung gestellt. Bei diesem Ansatz eignet sich das zu Figur 3 erläuterte Vorgehen besonders, in dem der Einlernvorgang auf eine Cloud 50 oder jedenfalls nach extern ausgelagert ist, wohin der Sensor 10 die Sensorsignale und gegebenenfalls die zugehörigen vorgegebenen Gegenstandsfeststellungssignale über die hinreichend breitbandig ausgestaltete Kommunikationsschnittstelle 48 überträgt. Dann ist die in der Einlernphase verfügbare Rechenleistung trotz einer weiterhin einfachen internen Auswertungseinheit 28 des Sensors 10 für alle praktischen Belange beliebig groß.

Der erfindungsgemäße Einlernvorgang ist bei Weitem nicht nur geeignet, eine klassische Schaltschwelle zu setzen. Vielmehr wird dadurch eine Flexibilität und Anpassbarkeit geschaffen, die das Anwendungsspektrum eines Sensors ganz erheblich erweitert. Herkömmlich werden für zahlreiche Anwendungen eigens angepasste Sensoren hergestellt, weil kein verfügbares Serienprodukt die speziellen Anforderungen erfüllt. Dazu sind echte Hardwareeingriffe, -erweiterungen und -umbauten erforderlich, wie ein Austausch von Sendeelementen für eine passende Wellenlänge, eine Modifikation der Optik sowie der Auswertung oder Firmware.

Erfindungsgemäß ist es nun möglich, einen Sensor 10 von vorneherein mit mehr beziehungsweise leistungsfähigeren Sensorelementen auszustatten als derzeit übliche Sensoren. Eine Lichtschranke umfasst also nicht mehr nur ihren Lichtsender und ihren Lichtempfänger, sondern beispielsweise eine in ihrer Wellenlänge umschaltbare Lichtquelle, eine zweite Empfängeroptik, einen in zusätzliche Lichtempfangselemente segmentierten Lichtempfänger oder auch Aufnehmer für Druck, Temperatur und Schall. Solche flexiblen Sensoren 10 werden dann für spezielle Anwendungen verbaut, die ein Standardsensor nicht lösen kann, um durch Zusatzsignale die Trennschärfe oder Unterscheidbarkeit von zu erfassenden Objekten zu verbessern.

In einem nicht-erfindungsgemäßen Beispiel weiß der Sensor 10 dann vorab auch nicht, wie die Sensorsignale zu einem passenden Gegenstandsfeststellungssignal zu verarbeiten sind, besitzt demnach keine eigens angepasste Auswertung. In der Einlernphase werden Sensorsignale der zu lösenden Detektionssituationen aufgenommen, vorzugsweise auch schon auf einem der beschriebenen Wege durch das gewünschte zugehörige Gegenstandsfeststellungssignal gelabelt. Der Sensor 10 dient also der Erzeugung von Trainingsdaten. Das eigentliche Training erfolgt in der Cloud 50, um den Sensor 10 einfach zu halten. Vor Ort muss also der Benutzer lediglich die Einlernphase starten und dafür sorgen, dass dann dem Sensor 10 die gewünschten Detektionssituationen präsentiert werden. Das entspricht meist einfach dem üblichen Betrieb, also beispielsweise durch Start der Anlage, wobei aber wie erläutert vorzugsweise Hilfsmittel 42, 44, 46 und/oder zusätzliche Sensoren 38 eingesetzt werden. Anschließend werden die Trainingsdaten an den Hersteller des Sensors 10 oder einen entsprechenden Dienstleister geschickt, der die Cloud 50 betreibt. Die Auswertungseinheit 28 empfängt nach diesem vorzugsweise vollautomatischen Prozess den Schaltpunkt, insbesondere als fertig trainierten Klassifikator, und ist damit in die Lage versetzt, die geforderte Anwendung zu lösen. Alternativ zu einem Training über die Cloud 50 ist aber weiterhin nicht ausgeschlossen, eine entsprechend leistungsfähige interne Auswertungseinheit 28 zu verwenden.

Durch den Einlernvorgang und insbesondere das Training eines auf maschinellem Lernen basierenden Klassifikators wird automatisch berücksichtigt, welcher Teil der verfügbaren Sensorinformation mit dem konkreten Problem korreliert. Es ist natürlich hilfreich, wenn der Sensor für die Erfassung von Informationen ausgebildet ist, von denen man vernünftigerweise annehmen kann, dass sie hilfreich sind, und umgekehrt offensichtlich irrelevante Informationen gar nicht erst erfasst oder beachtet, um das Training nicht unnötig zu erschweren.

Abschließend soll das erfindungsgemäße Einlernen noch einmal zusammengefasst werden. Dabei bedeuten die hier erwähnten Merkmale nicht, dass die Erfindung darauf beschränkt ist, und insbesondere die bereits erläuterten Variationsmöglichkeiten sollen hierdurch in keiner Weise relativiert werden.

Der Sensor 10 wird mit einem zusätzlichen Trainingseingang 32 für das gewünschte Gegenstandsfeststellungssignal *T* ausgerüstet. Die Einlernphase wird durch Bedienelemente am Sensor 10 oder eine Schnittstelle wie IO-Link aktiviert, woraufhin der Sensor 10 sein Sensorsignal für eine Vielzahl von Detektionssituationen erfasst, während ihm zugleich über den Trainingseingang 32 mitgeteilt wird, wie die jeweilige Detektionssituation zu bewerten ist (*T* = 0 oder *T* = 1). Dann folgt eine Optimierung, um einen Schaltpunkt im hier verwendeten verallgemeinerten Sinne zu finden, mit dem im Betrieb einem Sensorsignal ein Gegenstandsfeststellungssignal zugeordnet wird. Dieser Schaltpunkt soll möglichst robust und in möglichst guter Übereinstimmung mit den Vorgaben aus der Einlernphase sein.

Um dies zu erreichen, kann der Sensor 10 im Verbund mit Unterstützungsmitteln für die Einlernphase ausgeliefert oder verwendet werden. Das können zusätzliche Sensoren 38, wie eine Einweglichtschranke, ein Kontrasttaster oder ein taktiler Sensor samt denkbarer provisorischer Befestigungsmittel in auch ungewöhnlicher Montageposition, und/oder Hilfsmittel 42, 44, 46 wie ein Reflektorband oder ein farbiges beziehungsweise kontrastreiches Muster sein.

In einem nicht-erfindungsgemäßen Beispiel verfügt der Sensor 10 über eine Kommunikationsschnittstelle 48, um Sensorsignale oder bereits gelabelte Trainingsdaten in eine Cloud 50 zu übermitteln. Dann wird also eine Serverarchitektur bereitgestellt, um automatisch den Schaltpunkt aus den Trainingsdaten abzuleiten, insbesondere in Form einer geeigneten Transferfunktion für *Q* = *f*(*S*), Parametern für eine bereits festgesetzte Transferfunktion, wie eine Schwelle *Th,* oder einen Klassifikator, speziell ein fertig trainiertes neuronales Netz, das als Ganzes oder in Form seiner Verknüpfungen und Gewichte an den Sensor 10 zurückgespielt wird. Das kann ein Serviceangebot zur automatisierten oder halbautomatischen kundenspezifischen Anpassung ("Customising") von Sensoren 10 an kritische oder besonders fordernde Applikationen sein.

In Erweiterung ist es denkbar, einen Sensor 10 auf mehrere Situationen einzulernen, also mehrere Schaltpunkte aus mehreren Abfolgen einer Vielzahl von Detektionssituationen zu bestimmen. Beispiele sind Einsatz bei Tag und Nacht oder für wechselnde Chargen von Objekten 20. Dann ist es möglich, die Funktion des Sensors 10 ohne Einlernvorgang sehr rasch umzuschalten, gegebenenfalls auch gleitend etwa zwischen der Tag- und Nachteinstellung bei Dämmerung oder bedecktem Himmel.

Weiterhin kann beim Ableiten des Schaltpunktes auch ein Gütemaß bestimmt werden. Die meisten Optimierungen liefern so etwas mit. Im Beispiel der Figur 4 wäre dafür der Abstand zwischen den beiden Clustern *T* = 0 und *T* = 1 geeignet. Bei einem Klassifikator auf Basis von maschinellem Lernen kann man einen Teil der Trainingsdaten separieren und als Testdaten verwenden. Das Gütemaß ist an sich schon eine wertvolle Information über die Qualität des eingelernten Schaltpunkts. Es ermöglicht auch, das Einlernen unter verschiedenen Bedingungen zu wiederholen, etwa bei anderen Parametern für das Sensorelement 36 oder in unterschiedlichen Erfassungspositionen des Sensors 10, natürlich nur im Rahmen dessen, was die Anwendung zulässt. Dann kann man aufgrund des Gütemaßes die besten Einsatzbedingungen für den Sensor 10 finden.

Der Sensor 10 kann beim Einlernen eine eigene Bewertung beitragen. So gibt es auch nicht-überwachte Trainingsmöglichkeiten (unsupervised learning) und deterministische Algorithmen beispielsweise um eine geeignete Schwelle zu setzen. Das Einlernen muss auch kein einmaliger Vorgang bleiben, sondern es kann ein Nachlernen zum Nachführen an veränderte Rahmenbedingungen oder zur Berücksichtigung zusätzlicher Detektionssituationen stattfinden. In diesem Fall fängt der Sensor 10 nicht "bei Null" an, sondern mit dem bisher eingelernten Schaltpunkt, und die Bewertung durch diesen Schaltpunkt, insbesondere der bisherige trainierte Klassifikator, fließt in das Labeling der Trainingsdaten beziehungsweise die Bestimmung des neuen Schaltpunktes mit ein.

## Patentansprüche

1. System mit einem Sensor (10) zur Erfassung eines Objekts (20) in einem Überwachungsbereich (18) und mit mindestens einem zusätzlichen Sensor (38), wobei der Sensor (10) zur Erfassung des Objekts (20) ausgestattet ist mit mindestens einem Sensorelement (36) zum Erfassen eines Sensorsignals, mit einem Schaltausgang (30) zur Ausgabe eines binären Gegenstandsfeststellungssignal und mit einer Auswertungseinheit (28),
wobei die Auswertungseinheit (28) dafür ausgebildet ist, das Gegenstandsfeststellungssignal in Abhängigkeit von dem erfassten Objekt (20) aus dem Sensorsignal zu erzeugen sowie in einer Einlernphase einen Schaltpunkt zu bestimmen, der die Zuordnung zwischen Sensorsignal und Gegenstandsfeststellungssignal festlegt,
wobei die Auswertungseinheit (28) weiterhin dafür ausgebildet ist, in der Einlernphase ein jeweiliges Sensorsignal für eine Vielzahl von Detektionssituationen zu erfassen, wobei das zugehörige Gegenstandsfeststellungssignal für die jeweilige Detektionssituation vorgegeben wird, und daraus den Schaltpunkt abzuleiten,
wobei das zugehörige Gegenstandsfeststellungssignal für die jeweilige Detektionssituation durch den mindestens einen zusätzlichen Sensor (38) vorgegeben wird und der mindestens eine zusätzliche Sensor (38) dafür ausgebildet ist, das vorgegebene Gegenstandsfeststellungssignal zu erzeugen, die Detektionssituationen der Einlernphase zu bewerten und diese Bewertung dem Sensor (10) zur Erfassung des Objekts (10) für dessen als Trainingsphase für ein überwachtes Training des Schaltpunkts ausgestaltete Einlernphase vorzugeben.

2. System nach Anspruch 1, wobei der Sensor (10) zur Erfassung des Objekts einen Trainingseingang (32) für das vorgegebene Gegenstandsfeststellungssignal aufweist.

3. System nach Anspruch 2, wobei ein Schaltausgang (40) des zusätzlichen Sensors (38) an den Trainingseingang (32) angeschlossen ist.

4. System nach einem der vorhergehenden Ansprüche, wobei der zusätzliche Sensor (38) ein anderes Sensorsignal erfasst als der Sensor (10) zur Erfassung des Objekts und/oder das Sensorsignal auf andere Weise auswertet.

5. System nach einem der vorhergehenden Ansprüche, wobei der zusätzliche Sensor (38) in einer Position und/oder auf eine Weise angeordnet ist, die keiner für den Sensor (10) zur Erfassung des Objekts während des Betriebs möglichen Position und/oder Weise entspricht.

6. System nach einem der vorhergehenden Ansprüche, wobei aus den in der Einlernphase erfassten Sensorsignalen mindestens ein ein- oder mehrdimensionales Histogramm gebildet und der Schaltpunkt aus dem Histogramm abgeleitet wird.

7. System nach einem der vorhergehenden Ansprüche, wobei der Schaltpunkt mindestens eine Schwelle oder eine Grenzkurve aufweist.

8. System nach einem der vorhergehenden Ansprüche, wobei der Schaltpunkt einen Klassifikator aufweist, insbesondere einen Klassifikator nach einem Verfahren des maschinellen Lernens.

9. System nach einem der vorhergehenden Ansprüche, wobei der Sensor (10) zur Erfassung des Objekts eine Lichtschranke oder ein Lichttaster ist.

10. System nach einem der vorhergehenden Ansprüche, wobei der Sensor (10) zur Erfassung des Objekts eine Vielzahl von Sensorelementen (36) mit unterschiedlichen Eigenschaften aufweist.

11. Verfahren zum Einstellen eines Schaltpunkts eines Sensors (10), der Objekte (20) in einem Überwachungsbereich (18) erfasst, indem ein Sensorsignal erfasst, daraus ein binäres Gegenstandsfeststellungssignal erzeugt und auf einem Schaltausgang (30) ausgegeben wird, wobei der Schaltpunkt die Zuordnung zwischen Sensorsignal und Gegenstandsfeststellungssignal festlegt und in einer Einlernphase bestimmt wird, in der ein jeweiliges Sensorsignal für eine Vielzahl von Detektionssituationen erfasst wird, wobei das zugehörige Gegenstandsfeststellungssignal für die jeweilige Detektionssituation vorgegeben wird, indem mindestens ein zusätzlicher Sensor (38) das vorgegebene Gegenstandsfeststellungssignal erzeugt, der die Detektionssituationen der Einlernphase bewertet und diese Bewertung dem Sensor (10) für dessen als Trainingsphase für ein überwachtes Training des Schaltpunkts ausgestaltete Einlernphase vorgibt, und daraus der Schaltpunkt abgeleitet wird.

12. Verfahren nach Anspruch 11,
wobei der zusätzliche Sensor (38) nur vorübergehend während der Einlernphase vorgesehen ist.

13. Verfahren nach Anspruch 11 oder 12,
wobei während der Einlernphase vorübergehend mindestens ein die Erfassung eines Sensorsignals veränderndes Objekt (42, 44, 46) in dem Überwachungsbereich (18) angeordnet wird.

## Claims

1. System having a sensor (10) for detecting an object (20) in a monitored zone (18) and at least one additional sensor (38),
wherein the sensor (10) for detecting the object (20) comprises at least one sensor element (36) configured to detect a sensor signal, a switch output (30) configured to output a binary object determination signal and an evaluation unit (28),
wherein the evaluation unit (28) is configured to generate the object determination signal from the sensor signal in dependence on the detected object (20) and to determine, in a teaching phase, a switching point that determines the association between the sensor signal and the object determination signal,
wherein the evaluation unit (28) is further configured to detect a respective sensor signal for a plurality of detection situations in the teaching phase, with the associated object determination signal being preset for the respective detection situation and with the switching point being derived therefrom,
wherein the associated object determination signal is preset by the at least one additional sensor (38) and the at least one additional sensor (38) is configured to generate the preset object determination signal, to evaluate the detection situation of the teaching phase and to preset this evaluation to the sensor (10) for detecting the object (20) for its teaching phase that is a training phase for a supervised training of the switching point.

2. The system in accordance with claim 1,
wherein the sensor (10) for detecting the object (20) has a training input (32) for the preset object determination signal.

3. The system in accordance with claim 2,
wherein a switch output (40) of the additional sensor (38) is connected to the training input (32).

4. The system in accordance with any of the preceding claims,
wherein the additional sensor (38) detects a different sensor signal than the sensor (10) for detecting the object (20) and/or evaluates the sensor signal in a different manner.

5. The system in accordance with any of the preceding claims,
wherein the additional sensor (38) is arranged in a position and/or in a manner that does not correspond to any of the positions and/or manners possible for the sensor (10) for detecting the object (20) during operation.

6. The system in accordance with any of the preceding claims,
wherein at least one one-dimensional or multi-dimensional histogram is formed from the sensor signals detected in the teaching phase and the switching point is derived from the histogram.

7. The system in accordance with any of the preceding claims,
wherein the switching point has at least one threshold or a boundary curve.

8. The system in accordance with any of the preceding claims,
wherein the switching point has a classifier, in particular a classifier in accordance with a method of machine teaching.

9. The system in accordance with any of the preceding claims,
wherein the sensor (10) for detecting the object (20) is a light barrier or a light sensor using a scanning principle.

10. The system in accordance with any of the preceding claims,
wherein the sensor (10) for detecting the object (20) has a plurality of sensor elements having different properties.

11. A method of setting a switching point of a sensor (10) that detects objects (20) in a monitored zone (18) in that a sensor signal is detected, a binary object determination signal is generated therefrom and is output at a switching output (30), wherein the switching point determines the association between the sensor signal and the object determination signal and is determined in a teaching phase during which a respective sensor signal for a plurality of detection situations is detected, with the associated object determination signal being preset for the detection situation in that at least one additional sensor (38) generates the preset object determination signal, the additional sensor (38) evaluating the detection situation of the teaching phase und presetting this evaluation to the sensor (10) for its teaching phase that is a training phase for a supervised training of the switching point, and with the switching point being derived from that.

12. The method according to claim 11,
wherein the additional sensor (38) is only provided temporarily during the teaching phase.

13. The method according to claim 11 or 12,
wherein at least one object (42, 44, 46) changing the detection of a sensor signal is at least temporarily arranged in the monitored zone (18) during the teaching phase.

## Revendications

1. Système comportant un capteur (10) de détection d'un objet (20) dans une zone à surveiller (18) et au moins un capteur supplémentaire (38),
dans lequel le capteur (10) de détection de l'objet (20) est équipé d'au moins un élément capteur (36) pour détecter un signal de capteur, d'une sortie de commutation (30) pour émettre un signal binaire de constatation d'objet et d'une unité d'évaluation (28),
l'unité d'évaluation (28) est réalisée pour générer le signal de constatation d'objet à partir d'un signal de capteur en fonction de l'objet détecté (20) et pour déterminer, lors d'une phase d'apprentissage, un point de commutation qui définit l'association entre le signal de capteur et le signal de constatation d'objet,
l'unité d'évaluation (28) est en outre réalisée pour détecter, dans la phase d'apprentissage, un signal de capteur respectif pour une multitude de situations de détection, le signal de constatation d'objet associé étant prédéterminé pour la situation de détection respective, et pour en dériver le point de commutation,
le signal de constatation d'objet associé pour la situation de détection respective est prédéterminé par ledit au moins un capteur supplémentaire (38), et
ledit au moins un capteur supplémentaire (38) est réalisé pour générer le signal de constatation d'objet prédéterminé, pour évaluer les situations de détection de la phase d'apprentissage et pour imposer cette évaluation au capteur (10) de détection de l'objet (10) pour sa phase d'apprentissage conçue comme phase d'entraînement en vue d'un entraînement surveillé du point de commutation.

2. Système selon la revendication 1,
dans lequel le capteur (10) de détection de l'objet présente une entrée d'entraînement (32) pour le signal de constatation d'objet prédéterminé.

3. Système selon la revendication 2,
dans lequel une sortie de commutation (40) du capteur supplémentaire (38) est raccordée à l'entrée d'entraînement (32).

4. Système selon l'une des revendications précédentes,
dans lequel le capteur supplémentaire (38) détecte un autre signal de capteur que le capteur (10) de détection de l'objet et/ou il évalue le signal de capteur d'une autre manière.

5. Système selon l'une des revendications précédentes,
dans lequel le capteur supplémentaire (38) est agencé dans une position et/ou d'une manière qui ne correspond à aucune position et/ou à aucune manière possible pour le capteur (10) de détection de l'objet pendant le fonctionnement.

6. Système selon l'une des revendications précédentes,
dans lequel au moins un histogramme unidimensionnel ou multidimensionnel est formé à partir des signaux de capteur détectés pendant la phase d'apprentissage, et le point de commutation est dérivé à partir de l'histogramme.

7. Système selon l'une des revendications précédentes,
dans lequel le point de commutation présente au moins un seuil ou une courbe limite.

8. Système selon l'une des revendications précédentes,
dans lequel le point de commutation présente un classificateur, en particulier un classificateur selon une méthode de l'apprentissage machine.

9. Système selon l'une des revendications précédentes,
dans lequel le capteur (10) de détection de l'objet est une barrière lumineuse ou un détecteur de lumière.

10. Système selon l'une des revendications précédentes,
dans lequel le capteur (10) de détection de l'objet présente une multitude d'éléments capteurs (36) ayant différentes propriétés.

11. Procédé de réglage d'un point de commutation d'un capteur (10) qui détecte des objets (20) dans une zone à surveiller (18), en détectant un signal de capteur, en en générant un signal binaire de constatation d'objet et en l'émettant à une sortie de commutation (30), dans lequel le point de commutation définit l'association entre le signal de capteur et le signal de constatation d'objet et est prédéterminé pendant une phase d'apprentissage dans laquelle un signal de capteur respectif est détecté pour une multitude de situations de détection, le signal de constatation d'objet associé est prédéterminé pour la situation de détection respective du fait qu'au moins un capteur supplémentaire (38) génère le signal de constatation d'objet prédéterminé, il évalue la situation de détection de la phase d'apprentissage et il impose cette évaluation audit capteur (10) pour sa phase d'apprentissage conçue comme phase d'entraînement en vue d'un entraînement surveillé du point de commutation, pour en dériver le point de commutation.

12. Procédé selon la revendication 11,
dans lequel le capteur supplémentaire (38) n'est prévu que provisoirement pendant la phase d'apprentissage.

13. Procédé selon la revendication 11 ou 12,
dans lequel pendant la phase d'apprentissage, au moins un objet (42, 44, 46) modifiant la détection d'un signal de capteur est agencé provisoirement dans la zone à surveiller (18).
